**Europäisches Patentamt**

**European Patent Office**

**Office européen des brevets**

(19)

(11) Numéro de publication: **0 035 438**
**B1**

(12) **FASCICULE DE BREVET EUROPEEN**

(45) Date de publication du fascicule du brevet: **28.09.83**

(21) Numéro de dépôt: **81400285.3**

(22) Date de dépôt: **24.02.81**

(51) Int. Cl.³: **H 01 L 21/50,**
**H 01 L 23/04, H 01 L 23/10**

(54) Procédé d'encapsulation hermétique de composants électroniques à très haute fréquence comportant la pose de traversées métalliques, dispositif réalisé par un tel procédé.

(30) Priorité: **26.02.80 FR 8004208**

(43) Date de publication de la demande:
**09.09.81 Bulletin 81/36**

(45) Mention de la délivrance du brevet:
**28.09.83 Bulletin 83/39**

(84) Etats contractants désignés:
**DE GB NL**

(56) Documents cités:
**DE - A - 2 026 741**
**FR - A - 2 118 752**
**GB - A - 1 474 902**
**US - A - 3 676 569**

(73) Titulaire: **THOMSON-CSF**
**173, Boulevard Haussmann**
**F-75379 Paris Cedex 08 (FR)**

(72) Inventeur: **Resneau, Jean-Claude**
**THOMSON-CSF SCPI 173, bld Haussmann**
**F-75360 Paris Cedex 08 (FR)**
Inventeur: **Doyen, Jean**
**THOMSON-CSF SCPI 173, bld Haussmann**
**F-75360 Paris Cedex 08 (FR)**
Inventeur: **Ribier, Robert**
**THOMSON-CSF SCPI 173, bld Haussmann**
**F-75360 Paris Cedex 08 (FR)**

(74) Mandataire: **Taboureau, James et al,**
**THOMSON-CSF SCPI 173, Bld Haussmann**
**F-75379 Paris Cedex 08 (FR)**

Courier Press, Leamington Spa, England.

Procéde d'encapsulation hermétique de composants électroniques à très haute fréquence, comportant la pose de traversées métalliques, dispositif réalisé par un tel procédé

L'invention concerne un procédé d'encapsulation hermétique de composants à très haute fréquence sous forme d'un dispositif, comportant des traversées de conducteurs métalliques.

On sait que les traversées étanches par perles de verre sont prohibées en très haute fréquence en raison des pertes d'énergie dans le verre. On a donc recours à des traversées entre deux pièces de céramique qui sont par exemple le fond et les parois latérales d'un boitier de composant. Deux cas principaux sont à envisager:

Premier cas: Les pièces sont en céramique isolante polycristalline par exemple en alumine frittée, laquelle constitue un isolant de choix en très haute fréquence. Dans ce cas les conducteurs sont réalisés par exemple sous forme de métallisations déposées sur l'alumine du fond du boitier. Généralement ce fond constitue une plaque de dimensions supérieures à celle du fond proprement dit, ce dernier étant limité par un cadre matérialisant les parois latérales du boitier. Les métallisations dépassent les parois et traversent de façon étanche entre cadre et plaque, grâce à un scellement effectué généralement en utilisant un verre à haute température de ramollissement, les métallisations étant prévues pour résister sans dommage à cette opération, par exemple en utilisant un alliage de molybdène et de manganèse.

Cette méthode à l'inconvénient d'introduire du verre, qui même en très petite quantité est une source de pertes en haute fréquence au niveau des traversées.

Deuxième cas: Les pièces sont en céramique crue avant assemblage de la plaque et du cadre constituant le fond et les bords du boitier. On connait en effet la technologie, relativement délicate, de l'alumine coulée, dite plastique, en feuilles d'épaisseur de l'ordre du millimètre (au cours du frittage postérieur, la feuille subit un retrait important et son épaisseur ne dépasse pas pratiquement le millimètre).

La plaque et le cadre sont réalisés par découpage d'une feuille d'alumine coulée. Pour obtenir un boitier dont les bords ont une hauteur supérieure au millimètre, il est alors nécessaire de superposer deux ou plusieurs feuilles.

La métallisation par sérigraphie des conducteurs du boitier est suivie d'un traitement thermique pour éliminer les solvants volatils de la pâte à sérigraphier.

Les pièces sont ensuite assemblées, maintenues en contact avec une légère pression, puis scellées par frittage à 1500°C environ.

L'herméticité est assurée par la diffusion d'alumine et de métal entre les pièces contigües pendant le frittage.

Les inconvénients, dans le deuxième cas, résultent du cout élevé de la technologie de l'alumine coulée, de la limitation de hauteur des bords du boitier lorsqu'on utilise en seul cadre tiré d'une feuille d'alumine coulée, enfin du retrait important des pièces après frittage de la céramique.

L'invention tend à éliminer les inconvénients des méthodes antérieures.

Le procédé selon l'invention comporte l'assemblage d'une première pièce en céramique et d'une deuxième pièce en céramique de même nature, la deuxième pièce comportant sur une grande face au moins une métallisation en alliage réfractaire à la température de frittage de la céramique, la métallisation étant destinée à constituer une traversée conductrice de la surface de contact entre les deux pièces.

Il est principalement caractérisé en ce qu'il comporte au moins une première étape de cuisson séparée des pièces à une température inférieure à la température normale de frittage de la céramique, et une deuxième étape de cuisson à la température normale de frittage, intervenant seulement après assemblage des deux pièces, maintenues l'une contre l'autre pendant la deuxième étape avec une pression au moins égale à 50 g/cm².

D'autres caractéristiques de l'invention ressortiront de la description qui suit, donnée à titre d'exemple non limitatif, et illustrée par les figures annexées parmi lesquelles:

La figure 1 représente en vue cavalière une partie d'un dispositif réalisé par le procédé de l'invention.

La figure 2 est un schéma éclaté d'une boitier un coupe transversale correspondant à la réalisation de la figure 1.

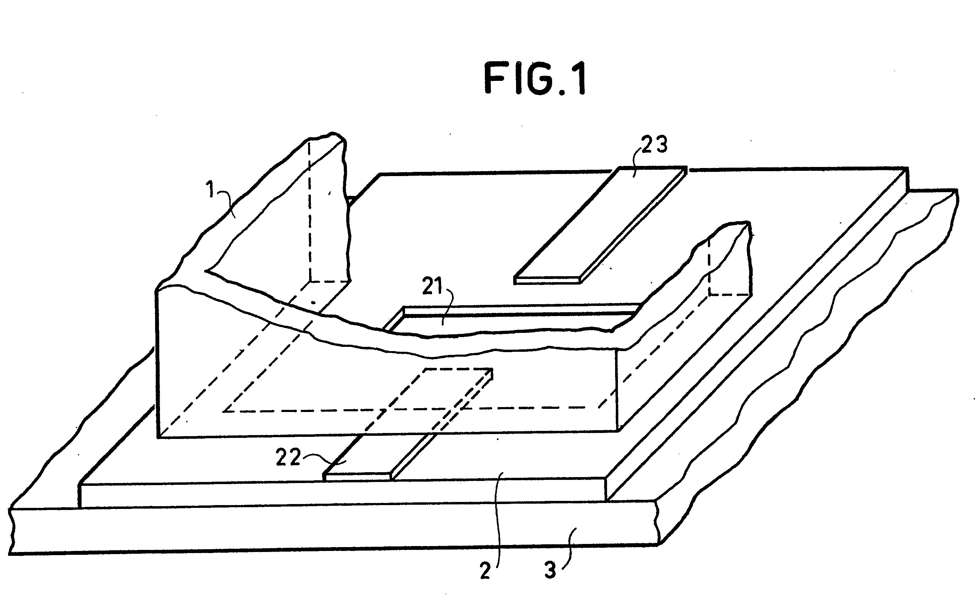

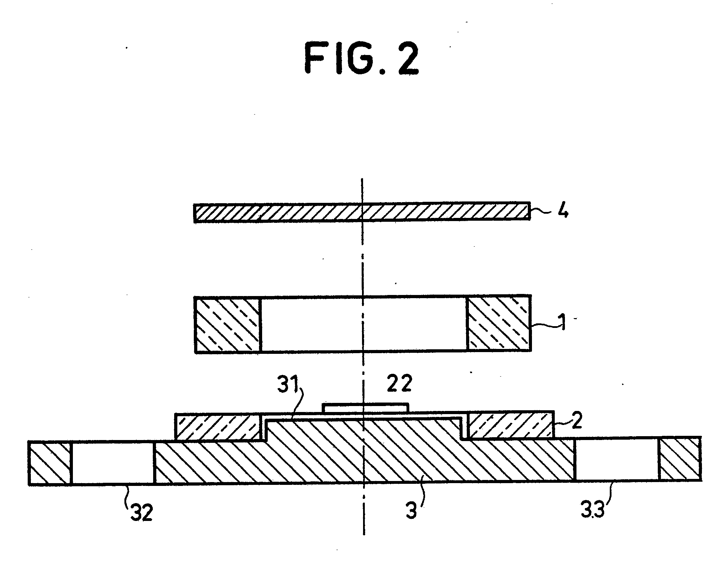

Dans l'exemple décrit et représenté sur les figures 1 et 2, une première pièce céramique du boitier est un cadre 1 en alumine, une deuxième pièce étant une plaque 2 en alumine du même type, les deux pièces ayant subi avant assemblage une même cuisson à une température inférieure à 1500°C, par exemple 1000°C.

La plaque 2 comporte une fenêtre centrale 21, destinée à permettre de mettre à la masse le composant à encapsuler. La masse du boitier est constituée par une plaque 3 relativement épaisse, par exemple 1 mm pour une plaque 2 de 0,6 mm d'épaisseur. Cette plaque, par exemple, en cuivre doré, est soudée par brasure à la plaque 2 ce qui assure l'herméticité autour de la fenêtre 21. La plaque 3 comporte par exemple une surélévation 31 qui se loge dans la fenêtre 21 de la plaque 2, pour faciliter la connexion du composant avec la masse.

La plaque 2 comporte, en outre, deux métallisations 22 et 23, par exemple en alliage de molybdène et de manganèse en couche d'une épaisseur de 10 microns. D'autres métaux ou alliages réfractaires à une température de 1500°C peuvent être utilisés, par exemple le tungstène. Le dépôt d'une telle métallisation peut être effectué par tout moyen classique, par exemple, par sérigraphie, pour une épaisseur de dix microns. L'épaisseur peut varier de quelques microns dans le cas d'un dépôt par évaporation sous vide à une trentaine de microns dans le cas d'un dépôt par sérigraphie.

Le procédé de réalisation comporte par exemple les étapes suivantes:

a) Fabrication de pièces en alumine crue par le technologie classique de préparation de pièces moulées sous pression en céramique crue additionnée de liants; elle comporte les opérations suivants:
— broyage de l'alumine pendant 24 heures par exemple en milieu aqueux en utilisant un outillage classique revêtu d'alumine et des billes en corindon;
— après séchage, mélange de la poudre d'alumine avec un liant organique destiné à faciliter la mise en forme des pièces;
— pressage des pièces dans les moules;
b) etape de cuisson à 1000°C pendant une durée pouvant varier d'une à quelques heures;
c) dépôt des métallisations 22 et 23 par sérigraphie à l'aide d'une pâte à sérigraphier contenant du molybdène et du manganèse, par exemple, ou encore du tungstène ou un autre matériau réfractaire et bon conducteur de l'électricité sur la plaque 2; éventuellement la face opposée de la plaque 2 et la partie supérieure du cadre 1 sont métallisées sur toute leur surface par la même méthode; l'épaisseur des métallisations est comprise entre 10 et 40 microns; séchage en étuve de l'ensemble à 100°C pour éliminer les solvants de la pâte à sérigraphier;
d) assemblage des pièces comportant la superposition du cadre 1 et de la plaque 2, le centrage du cadre 1 et la mise en compression par des moyens faisant partie ou non du four de cuisson;
e) etape de cuisson à 1500°C pendant une durée pouvant varier d'une à quelques heures;
f) dépôt, sur les faces inférieures et supérieures de l'assemblage, de métallisations destinées à faciliter la soudure par brasage avec un couvercle 4 d'une part en alliage de fer, nickel et cobalt (Kovar) et la plaque 3, si ces métallisations n'ont pas été effectuées à l'étape (c);
g) soudure par brasage de la plaque 2 sur la plaque 3, destinée à faciliter éventuellement l'évacuation de la chaleur dégagée par le composant électronique, en cas de puissance importante, et en tout cas à permettre la fixation du dispositif par utilisation de perforations 32 et 33 pratiquées en dehors de l'emprise de la plaque 2 sur la plaque 3;
h) montage du composant électronique, par exemple un transistor, par soudure aux métallisations 22 et 23 et à la surélévation 31;
i) soudure par brasage du couvercle 4 sur le cadre 1 avec apport de nickel.

L'invention est applicable à la fabrication d'une ligne triplaque, comportant comme on le sait, deux plans de masse isolés, par un diélectrique, par exemple de la céramique, d'un conducteur central. La céramique utilisée est par exemple de l'alumine, le conducteur central pouvant être déposé seulement sur l'une des plaques intermédiaires en céramique, entre la première et la deuxième étape de cuisson. Le dépôt des couches métalliques destinées à jouer le rôle de plans de masse n'intervient qu'après la deuxième étape de cuisson.

**Revendications**

1. Procédé d'encapsulation hermétique de composants électroniques à très haute fréquence, comportant l'assemblage d'une première pièce (1) en céramique et d'une deuxième pièce (2) en céramique de même nature, la deuxième pièce (2) comportant sur une grande face au moins une métallisation (22, 23) en alliage réfractaire à la température de frittage de la céramique, la métallisation étant destinée à constituer une traversée conductrice de la surface de contact des première et deuxième pièces (1, 2), le procédé étant caractérisé en ce qu'il comporte au moins une première étape de cuisson séparée des pièces (1, 2) à une température inférieure à la température normale de frittage de la céramique, et une deuxième étape de cuisson à la température normale de frittage intervenant seulement après assemblage des deux pièces (1, 2), maintenues l'une contre l'autre pendant la deuxième étape avec une pression au moins égale à 50 g/cm².

2. Procédé selon la revendication 1, caractérisé en ce qu'il comporte les étapes suivantes:

a) fabrication de pièces en alumine crue par broyage, séchage et pressage des pièces après addition de liants organiques;
b) cuisson à 1000°C pendant une durée d'une à plusieurs heures;
c) dépôt par sérigraphie de métallisations réfractaires destinées à constituer les traversées conductrices; séchage en étuve à 100°C;
d) assemblage des pièces et mise en compression de celles-ci;
e) cuisson à 1500°C pendant une durée d'une à quelques heures.

3. Procédé selon la revendication 2, caractérisé en ce qu'il comporte en outre les étapes suivantes:

f) dépôt de métallisations sur les faces de l'assemblage des pièces réalisées à l'étape (d) en vue de la soudure d'un couvercle et d'une plaque de dissipation calorifique;

g) montage du composant électronique à encapsuler, et finition du dispositif.

4. Dispositif d'encapsulation hermétique fabriqué par un procédé suivant l'une quelconque des revendications 1 à 3, caractérisé en ce que la première et la deuxième pièces sont respectivement un cadre destiné à constituer les parois latérales et une plaque destinée à constituer le fond d'un boitier de composant électronique.

5. Dispositif selon la revendication 4, caractérisé en ce qu'il comporte en outre un couvercle scellé et une plaque métallique de dissipation thermique scellée au fond du boitier, la plaque de dissipation thermique comportant une surélévation engagée dans une ouverture du fond du boitier.

6. Dispositif d'encapsulation hermétique fabriqué par un procédé selon l'une quelconque des revendications 1 à 3, caractérisé en ce que la première et la deuxième pièce sont des plaques isolantes d'une ligne triplaque dont le conducteur central est en métal réfractaire.

## Claims

1. Method of hermetical encapsulation of electronic very high frequency components, comprising the assembly of a first part (1) of ceramic material with a second part (2) of ceramic material of the same type, the second part (2) comprising on at least one major face a metallization (22, 23) of an alloy which is heat-resistant to the fritting temperature of the ceramic material, the metallization being provided for forming a conducting traverse on the contacting surfaces of the first and second parts (1, 2), the method being characterized in that it comprises at least a first step of baking the parts (1, 2) separately at a temperature below the normal fritting temperature of the ceramic material, and a second baking step at the normal fritting temperature occurring only after the assembly of the two parts (1, 2) which are urged one against the other at a pressure of at least 50 g/cm² during the second step.

2. Method in accordance with claim 1, characterized in that it comprises the following steps:

a) producing parts of ground crude alumina, pressing of the parts after the addition of organic binders;
b) baking at 1000°C for a duration of one to several hours;
c) Deposition of heat-resistant metallizations by serigraphy for forming the conducting traverses; drying in a baking oven at 100°C;
d) assembly of the parts and urging them one against another;
e) baking at 1500°C for a duration of one to several hours.

3. Method in accordance with claim 2, characterized in that it further comprises the following steps:

f) deposition of metallizations on the faces of the assembly of the parts formed in step (d) for the purpose of soldering thereto a cover and a heat dissipation plate;
g) mounting the electronic component to be encapsulated and finishing the device.

4. Hermetical encapsulation device formed by a method in accordance with any of claims 1 to 3, characterized in that the first and second parts are a frame for forming the lateral walls and a plate for forming the bottom of a package of an electronic component, respectively.

5. Device in accordance with claim 4, characterized in that it further comprises a sealed cover and a metallic heat dissipation plate sealed to the bottom of the package, the heat dissipation plate comprising an elevation engaged into an opening of the bottom of the package.

6. Hermetical encapsulation device formed by a method in accordance with any of claims 1 to 3, characterized in that the first and second parts are insulating plates of a three-plate line the central conductor of which is of a heat-resistant metal.

## Patentansprüche

1. Verfahren zum hermetischen Einkapseln von elektronischen Bauteilen für sehr hohe Frequenzen, bei welchem ein erstes Keramikteil (1) mit einem zweiten, gleichartigen Keramikteil (2) zusammengesetzt wird, wovon das zweite Teil (2) auf seiner Hauptfläche wenigstens eine Metallisierung (22, 23) aus einer bei der Frittungstemperatur der Keramik beständigen Legierung aufweist und wobei die Metallisierung dazu bestimmt ist, eine leitfähige Überquerung der Kontaktoberfläche des ersten und zweiten Teils (1, 2) zu bilden, wobei das Verfahren dadurch gekennzeichnet ist, daß es wenigstens eine erste Stufe umfaßt, auf der die Teile (1, 2) getrennt bei einer Temperatur gebrannt werden, die niedriger als die normale Frittungstemperatur der Keramik ist, und eine zweite Stufe umfaßt, bei der ein Brennen bei der normalen Frittungstemperatur erst nach dem Zusammensetzen der beiden Teile (1, 2) erfolgt, während diese unter einem Druck von wenigstens 50 g/cm² gegeneinander gehalten werden.

2. Verfahren nach Anspruch 1, dadurch gekennzeichnet, daß es folgende Stufen umfaßt:

a) Herstellung von Teilen aus zermahlenem Rohaluminiumoxid, Trocknen und Pressen der Teile nach Hinzufügung von organischen Bindemitteln;
b) Brennen bei 1000°C während einer Dauer von einer bis zu mehreren Stunden;

c) Aufbringen von hitzebeständigen Metallisierungen durch Siebdruck, die dazu bestimmt sind, die leitenden Überquerungen zu bilden; Trocknen bei 100°C in einem Trockenofen;

d) Zusammensetzen der Teile und Unterdrucksetzen derselben;

e) Brennen bei 1500°C während einer Dauer von einer bis zu mehreren Stunden.

3. Verfahren nach Anspruch 2, dadurch gekennzeichnet, daß es ferner die folgenden Stufen umfaßt.

f) Aufbringen von Metallisierungen auf den Flächen der im Schritt (d) gebildeten Einheit der Teile zum Zweck des Auflötens eines Deckels und einer Wärmeableitungsplatte;

g) Einbau des einzukapselnden elektronischen Bauteils und Endbearbeitung der Vorrichtung.

4. Vorrichtung zum hermetischen Einkapseln, die durch ein Verfahren nach einem der Ansprüche 1 bis 3 hergestellt ist, dadurch gekennzeichnet, daß das erste Teil ein Rahmen ist, der die Seitenwände des Gehäuses eines elektronischen Bauteils bilden soll, und das zweite Teil eine Platte ist, die den Boden dieses Gehäuses bilden soll.

5. Vorrichtung nach Anspruch 4, dadurch gekennzeichnet, daß sie ferner einen versiegelten Deckel und eine Metallplatte zur Wärmeableitung umfaßt, die an dem Boden des Gehäuses angesiegelt ist, wobei die Wärmeableitungsplatte eine Erhebung aufweist, die in eine Öffnung des Gehäusebodens eingesetzt ist.

6. Vorrichtung zum hermetischen Einkapseln, die durch ein Verfahren nach einem der Ansprüche 1 bis 3 hergestellt ist, dadurch gekennzeichnet, daß das erste Teil und das zweite Teil Isolierplatten einer aus drei Platten gebildeten Leitung sind, deren Mittenleiter ein hitzebeständiges Metall ist.

FIG.1

# FIG. 2